# EUROPÄISCHE PATENTSCHRIFT

(11) **EP 0 541 011 B1**
(45) Veröffentlichungstag und Bekanntmachung des Hinweises auf die Patenterteilung: **17.04.1996**
(21) Anmeldenummer: 92118576.5
(22) Anmeldetag: 30.10.1992
(51) Int. Cl.: C30B 23/02, H01L 39/24

(54) **Verfahren zur Herstellung eines SrTiO3-YBa2Cu3O7-Schichtsystems und Schichtsystem aus SrTiO3 und YBa2Cu3O7**
Process for producing a SrTiO3-YBa2Cu3O7 layered structure and layered structure consisting of SrTiO3 and YBa2Cu3O7
Procédé pour la préparation de SrTiO3-YBa2Cu3O7 sous forme de structure à couches et une structure à couches composée de SrTiO3 et YBa2Cu3O7

(30) Priorität: 02.11.1991 DE 4136126
(43) Veröffentlichungstag der Anmeldung: 12.05.1993
(73) Patentinhaber: FORSCHUNGSZENTRUM JÜLICH GMBH, D-52425 Jülich (DE)
(72) Erfinder: Soltner, Helmut, W-5176 Inden (DE); Poppe, Ulrich, Dr., W-5000 Köln 41 (DE); Urban, Knut, Prof., W-5170 Jülich (DE)

(56) Entgegenhaltungen:
- EP-A- 0 445 350
- APPLIED PHYSICS LETTERS. Bd. 58, Nr. 7, 18. Februar 1991, NEW YORK US Seiten 765 - 767 M.E.TIDJANI 'heteroepitaxial YBa2Cu3O7-x--SrTiO3--YBa2Cu3O7-x trilayers examined by transmission electron microscopy'

## Beschreibung

Die Erfindung bezieht sich auf ein Verfahren zur Herstellung eines Schichtsystems mit Substrat und c-Achsen-kristallorientierter YBa₂Cu₃O₇-Schicht sowie auf ein derartiges Schichtsystem.

c-Achsen-Kristallorientierung der YBa₂Cu₃O₇-Schicht liegt vor, wenn die Kupferoxidebenen parallel zur Substratoberfläche liegen. Eine solche Ausrichtung ist von Interesse, da dann bei einem leistungslosen Stromtransport besonders große Stromdichten möglich sind. Daher wird angestrebt, daß bei der Herstellung von YBa₂Cu₃O₇-Schichten ein c-Achsen-orientiertes Wachstum auftritt.

Es sind verschiedene Verfahren bekannt, die auf einem dafür geeigneten Substrat ein derartiges Wachstum bewirken. Beispielsweise entsteht durch Hochdruck-dc-Sputtern unter bestimmten Bedingungen ein Wachstum von YBa₂Cu₃O₇-Schichten mit c-Achsen-Orientierung. Die Art des Kristallwachstums wird dabei durch die geometrische Anordnung, Druck des Sputtergases, Ofen- bzw. Substrattemperatur, Wahl des Substrates und des Sputtergases sowie durch die Stromstärke während des Sputterns beeinflußt.

Jedoch kann selbst bei einer optimalen Wahl dieser Parameter nicht verhindert werden, daß mit zunehmender Schichtdicke auch a-Achsen-orientierte Bereiche entstehen. Sind dann diese einmal aufgetreten, so wird dadurch in zunehmendem Maße ein weiteres gleichmäßiges c-Achsen-orientiertes Wachstum verhindert. Der Fachwelt ist bisher keine Möglichkeit bekannt, hier Abhilfe zu schaffen.

Aufgabe der Erfindung ist es, ein Verfahren zu schaffen, das ein kontrollierbares, c-Achsen-orientiertes YBa₂Cu₃O₇-Wachstum ermöglicht, um damit zu einem Hochtemperatursupraleiter zu gelangen, der möglichst aus c-Achsen-orientierten Bereichen besteht.

Die Aufgabe wird durch das in Anspruch 1 genannte Verfahren gelöst.

Der Erfindung liegt also die Idee zugrunde, einem, bei größeren Schichtdicken unvermeidlichen, unkontrollierten Wachstum entgegenzuwirken, indem in eine supraleitende Schicht Zwischenschichten eingebracht werden, die ein weiteres, kontrolliertes c-Achsen-orientiertes Wachstum bewirken.

Es hat sich gezeigt, daß 20 nm bis 30 nm dicke SrTiO₃-Schichten hinreichen, um ein weiteres c-Achsen-orientiertes Kristallwachstum sicherzustellen.

Ein Hochtemperatursupraleiter, der anteilsmäßig mehr c-Achsen-orientierte Bereiche als bisher aufweist, besteht daher in Form eines Vielschichtsystems aus C-Achsen-kristallorientiertem YBa₂Cu₃O₇ und SrTiO₃, wobei SrTiO₃-Schichten 20 nm bis 30 nm dick sind, wenn diese sich zwischen zwei YBa₂Cu₃O₇-Schichten befinden.

Weiter stellte sich heraus, daß ein erfindungsgemäß optimierter Hochtemperatursupraleiter der genannten Art zudem aus YBa₂Cu₃O₇-Schichten, die 300 nm bis 500 nm dick sind, besteht.

Im folgenden wird ein Ausführungsbeispiel des erfindungsgemäßen Verfahrens anhand einer elektronenmikroskopischen Aufnahme eines SrTiO₃-YBa₂Cu₃O₇-Schichtsystems beschrieben.

Gezeigt wird ein unkontrolliert gewachsener Bereich einer YBa₂Cu₃O₇-Schicht 1, eine anschließend wenige nm dick aufgetragene SrTiO₃-Schicht 2, eine weiter unkontrolliert gewachsene YBa₂Cu₃O₇-Schicht 3 eine dann 20 nm bis 30 nm dick aufgetragene SrTiO₃-Schicht 5 und ein dadurch hervorgerufenes gleichmäßiges c-Achsen-orientiertes Wachstum der folgenden YBa₂Cu₃O₇-Schicht 7.

c-Achsen-orientierte Bereiche erscheinen in der Darstellung quer-, a-Achsen-orientierte Bereiche längsgestreift. Die 20 nm bis 30 nm dicke SrTiO₃-Schicht überdeckt die Stufe 6 und verursachte so ein c-Achsen-orientiertes Wachstum der YBa₂Cu₃O₇-Schicht 7. Es ist deutlich zu erkennen, daß dagegen die dünn aufgetragene SrTiO₃-Schicht 2 nicht in der Lage ist, die Stufe 4 zu überdecken und von dieser Stufe dann ein weiteres a-Achsen-orientierte Wachstum ausgeht.

Das Auftragen von YBa₂Cu₃O₇ erfolgte durch Hochdruck-dc Sputtern unter folgenden Bedingungen
- einzelnes stöchiometrisches Target mit 35 mm φ
- (100)-orientierter SrTiO₃-Kristall als Substrat
- 13 mm Abstand zwischen Target und Substrat
- Sauerstoff als Sputtergas bei einem Druck von 3,6 mbar
- Ofentemperatur von 880°C
- Oberflächentemperatur des Substrats bei 750°C
- Stromstärke während des Sputterns von 200 mA
- Sauerstoffnachbehandlung bei 550°C.

SrTiO₃-Schichten wurden durch Hochfrequenz-Sputtern bei einer Sinusspannung vom 1000 V, einer Wechselstromfrequenz von 7 MHz und unter ansonsten gleichen Bedingungen aufgebracht.

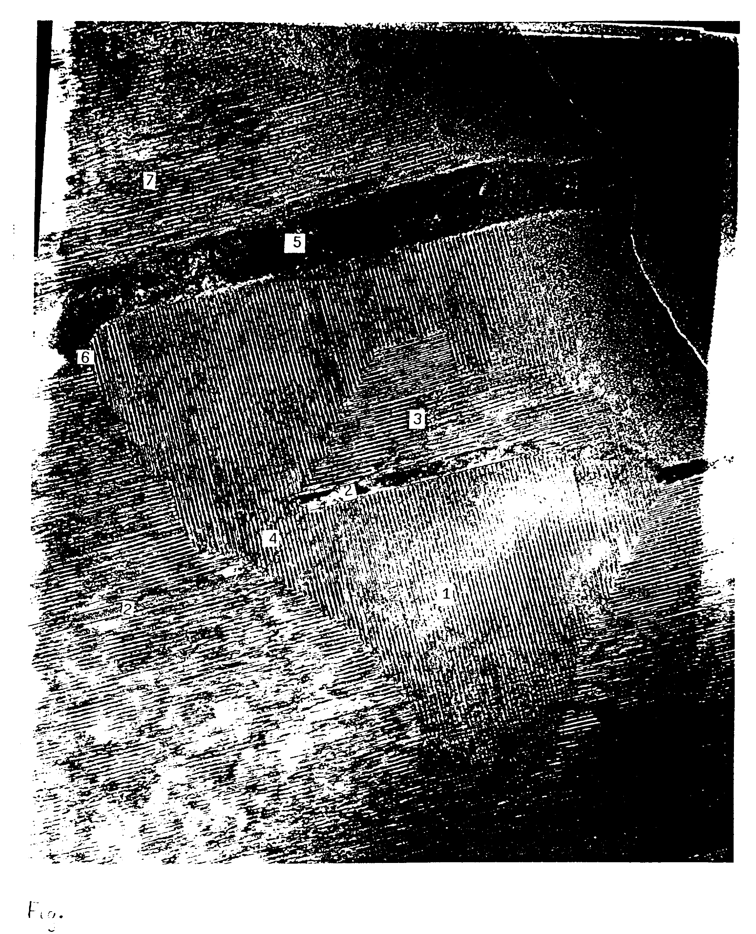

## Patentansprüche

1. Verfahren zur Herstellung eines Schichtsystems mit Substrat und darauf aufgewachsener c-Achsen kristallorientierter YBa₂Cu₃O₇-Schicht,
**dadurch gekennzeichnet**,
daß das Wachstum der YBa₂Cu₃O₇-Schicht bei Auftreten unerwünschter a-Achsen-orientierter Bereiche und dabei zwischen a-Achsen-und c-Achsen-orientierten Bereichen auf der YBa₂Cu₃O₇-Oberfläche entstandener Stufen unterbrochen, eine SrTiO₃-Schicht solange aufgetragen wird, bis die Stufen überdeckt sind und anschließend das Wachstum der YBa₂Cu₃O₇-Schicht fortgesetzt wird.

2. Verfahren nach Anspruch 1,
**dadurch gekennzeichnet,**
daß eine SrTiO₃-Schicht, die die Stufen auf der YBa₂Cu₃O₇-Schicht überdeckt, in einer Schichtdicke von 20 nm bis 30 nm aufgetragen wird.

3. Schichtsystem bestehend aus SrTiO₃ und c-Achsenkristallorientiertem YBa₂Cu₃O₇,
**dadurch gekennzeichnet,**
daß das Schichtsystem aus mehreren sich abwechselnden SrTiO₃- und YBa₂Cu₃O₇-Schichten besteht und die SrTiO₃-Schichten, die zwischen zwei YBa₂Cu₃O₇-Schichten liegen, 20 nm bis 30 nm dick sind.

4. Schichtsystem nach Anspruch 3,
**dadurch gekennzeichnet,**
daß YBa₂Cu₃O₇-Schichten 300 nm bis 500 nm dick sind.

## Claims

1. Process for the manufacture of a layer system with substrate and a c-axes crystal-oriented YBa₂Cu₃O₇-layer grown thereonto, **characterized in that**, in the event of undesirable a-axes-oriented areas and thus between a-axes- and c-axes oriented areas on steps which have developed on the YBa₂Cu₃O₇ surface, the growth of the YBa₂Cu₃O₇-layer is suspended, a SrTiO₃-layer is applied until the steps are covered, whereafter the growth of the YBa₂Cu₃O₇-layer is continued.

2. Process according to Claim 1, **characterized in that** a SrTiO₃-layer, which covers the steps on the YBa₂Cu₃O₇-layer, is applied at a layer thickness between 20 and 30 nm.

3. Layer system composed of SrTiO₃ and c-axes-crystal oriented YBa₂Cu₃O₇, **characterized in that** the layer system is composed of a plurality of alternating SrTiO₃- and YBa₂Cu₃O₇- layers, and the SrTiO₃-layers, which are located between two YBa₂Cu₃O₇-layers, are between 20 and 30 nm thick.

4. Layer system according to Claim 3, **characterized in that** YBa₂Cu₃O₇-layers are between 300 and 500 nm thick.

## Revendications

1. Procédé de fabrication d'un système stratifié avec un substrat sur lequel se développe une couche de YBa₂Cu₃O₇ à cristaux orientés selon un axe c, caractérisé en ce que la croissance de la couche de YBa₂Cu₃O₇ est interrompue lors de l'apparition de domaines indésirés orientés selon un axe a et de niveaux formés sur la surface de YBa₂Cu₃O₇ entre des domaines orientés selon l'axe a et des domaines orientés selon l'axe c, on applique une couche de SrTiO₃ jusqu'à ce que ces niveaux soient recouverts, et ensuite, on continue la croissance de la couche de YBa₂Cu₃O₇.

2. Procédé selon la revendication 1, caractérisé en ce qu'on applique une couche de SrTiO₃, à raison d'une épaisseur de couche de 20 nm à 30 nm, qui recouvre les niveaux sur la couche de YBa₂Cu₃O₇.

3. Système stratifié formé de SrTiO₃ et de YBa₂Cu₃O₇ à cristaux orientés selon l'axe c, caractérisé en ce qu'il est formé de plusieurs couches alternées de SrTiO₃ et de YBa₂Cu₃O₇, et les couches de SrTiO₃ qui sont situées entre deux couches de YBa₂Cu₃O₇ ont une épaisseur de 20 nm à 30 nm.

4. Système stratifié selon la revendication 3, caractérisé en ce que des couches de YBa₂Cu₃O₇ ont une épaisseur de 300 nm à 500 nm.
